# EUROPEAN PATENT SPECIFICATION

(11) **EP 2 964 007 B1**
(45) Date of publication and mention of the grant of the patent: **22.07.2020**
(21) Application number: 13876183.8
(22) Date of filing: 26.02.2013
(51) Int. Cl.: H05K 13/08, H05K 13/04

(54) **COMMUNICATION SYSTEM AND ELECTRONIC COMPONENT MOUNTING DEVICE**
KOMMUNIKATIONSSYSTEM UND VORRICHTUNG ZUR MONTAGE ELEKTRONISCHER KOMPONENTEN
SYSTÈME DE COMMUNICATION ET DISPOSITIF DE MONTAGE DE COMPOSANT ÉLECTRONIQUE

(43) Date of publication of application: 06.01.2016
(73) Proprietor: FUJI Corporation, Chiryu Aichi (JP)
(72) Inventor: NAGASAKA, Nobuo, Chiryu, Aichi (JP); JINDO, Takahiro, Chiryu, Aichi (JP); IMADERA, Yasuaki, Chiryu, Aichi (JP); HIROTA, Shigemoto, Chiryu, Aichi (JP)
(74) Representative: Grünecker Patent- und Rechtsanwälte PartG mbB
(86) International application number: PCT/JP2013/054851
(87) International publication number: WO 2014/132324

(56) References cited:
- EP-A2- 1 868 313
- JP-A- H06 164 192
- JP-A- 2006 279 927
- JP-A- 2011 124 605
- JP-A- 2013 026 439
- JP-A- 2013 026 439

## Description

### Technical Field

The present invention relates to a communication system that transmits processing results of an imaging device having an image processing function and an electronic component mounting device using the communication system.

### Background Art

Automatic machines, such as electronic component mounting devices or industrial robots, which operate in various manufacturing lines, perform, for example, work for mounting workpieces, such as electronic components, which are held by movable portions, such as mounting heads or arms, on circuit boards. The automatic machine performs mounting work on the basis of a control program, and adjusts positions when the actual positions of the electronic component of the movable portion and the circuit board deviate from desired relative positions set in the control program. For example, there is an automatic machine including an imaging device that images an electronic component to be held and performs image processing and is provided on the movable portion (PTL 1 and the like). For example, the imaging device performs image processing for detecting the amount of the deviation of the orientation and the position of an electronic component and the like from obtained image data. The imaging device transmits the processing results to a control unit through a network. The control unit drives the movable portion on the basis of the processing results received from the imaging device, to adjust the orientation of the electronic component through rotation and the like of the electronic component.

Meanwhile, when the control unit detects abnormality on the basis of the processing results of the imaging device, for example, when the orientation of the electronic component is abnormal so that the electronic component held by the movable portion cannot be adjusted, this kind of automatic machine transmits the data of an actual image, which is taken by the imaging device, as it is and displays the data on a monitor. The amount of data of an actual image, which is not subjected to image processing, becomes larger than the amount of data of the processing results, such as the amount of the deviation of the orientation and the position of the electronic component obtained from image processing. For this reason, since the transmission time of the actual image becomes longer than the transmission time of the processing results when the actual image is transmitted as it is, a connection port for the network is used for an extended period of time. In a technique disclosed in PTL 1, two virtual interfaces (command interfaces CF1 and CF2 in PTL 1) are realized at one physical connection port connected to a network (Ethernet (registered trademark) in PTL 1), and the interfaces are separately used for image processing result data and actual image data.

A communication system according to the preamble of independent claim 1 is known from PTL 2. Another example is known from PTL3.

### Citation List

### Patent Literature

PTL 1: JP-A-2009-218933
PTL 2: EP 1 868 313 A2
PTL 3: JP 2013 026439 A

### Summary of Invention

### Technical Problem

Since image processing is performed on a movable portion in the configuration in which an imaging device having an image processing function is provided on the movable portion, it is possible to reduce the amount of data transmitted to a network. As a result, the data transmission speed of a communication line is reduced. However, since a small amount of processing result data and a large amount of actual image data are transmitted through one physical line in a communication system that is applied to the automatic machine of PTL 1, it is necessary to provide a communication line of which data transmission speed is increased according to the transmission of a large amount of data that temporarily occurs in a working process such as a case in which an electronic component is sucked and held abnormally. Accordingly, when data is finally transmitted through the same communication line even though the interfaces are used separately, it is necessary to sufficiently ensure the bandwidth of a communication line according to a large amount of data that is temporarily transmitted when an abnormality occurs. When a small amount of data is normally transmitted, transmission efficiency is reduced. Consequently, there is a problem in that an increase in manufacturing cost may occur.

The invention has been made in consideration of the above-mentioned problem, and an object of the invention is to provide a communication system in which transmission efficiency is improved by the optimization of a communication line according to the amount of data to be transmitted and manufacturing costs are consequently reduced, and an electronic component mounting device using the communication system.

### Solution to Problem

The invention is defined by independent claim 1. Preferred embodiments are set out in the dependent claims.

A communication system according to a technique disclosed in this application includes a movable portion that holds and moves a workpiece, an imaging device that is integrally provided on the movable portion and performs image processing for extracting necessary information from image data of a state in which the movable portion holds the workpiece, a control unit that drives the movable portion on the basis of processing result data of the image processing performed by the imaging device, first communication means for transmitting the processing result data to the control unit from the imaging device, and second communication means other than the first communication means. The control unit transmits the image data from the imaging device on the basis of the processing result data by the second communication means.

Further, an electronic component mounting device according to a technique disclosed in this application transmits data related with work for mounting an electronic component, which is held as the workpiece by the movable portion, on a circuit board by the communication system according to the technique disclosed in this application. That is, the communication system includes a movable portion that holds and moves a workpiece, an imaging device that is integrally provided on the movable portion and performs image processing for extracting necessary information from image data of a state in which the movable portion holds the workpiece, a control unit that drives the movable portion on the basis of processing result data of the image processing performed by the imaging device, first communication means for transmitting the processing result data to the control unit from the imaging device, and second communication means other than the first communication means. The control unit transmits the image data from the imaging device on the basis of the processing result data by the second communication means.

### Advantageous Effects of Invention

According to a communication system and an electronic component mounting device of the technique disclosed in this application, it is possible to provide a communication system in which transmission efficiency is improved by the optimization of a communication line according to the amount of data to be transmitted and manufacturing costs are consequently reduced, and an electronic component mounting device using the communication system.

### Brief Description of Drawings

[Fig. 1] Fig. 1 is a perspective view of an electronic component mounting device including a communication system according to an embodiment.
[Fig. 2] Fig. 2 is a perspective view of a mounting head that is included in the electronic component mounting device.
[Fig. 3] Fig. 3 is a partial enlarged view of the mounting head.
[Fig. 4] Fig. 4 is a perspective view of an electronic component supply device that is included in the electronic component mounting device.
[Fig. 5] Fig. 5 is a schematic configuration diagram illustrating data transmission in the communication system.

### Description of Embodiments

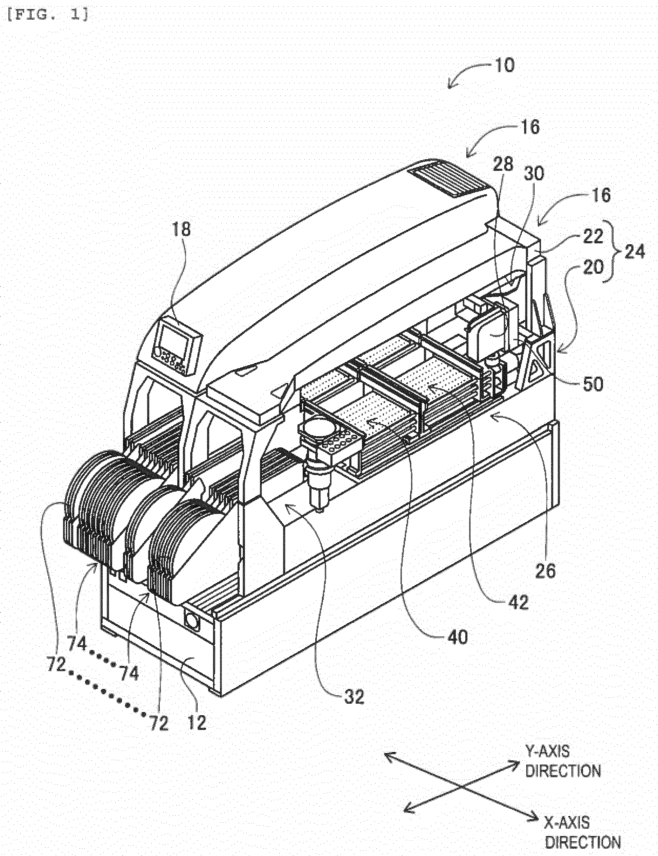

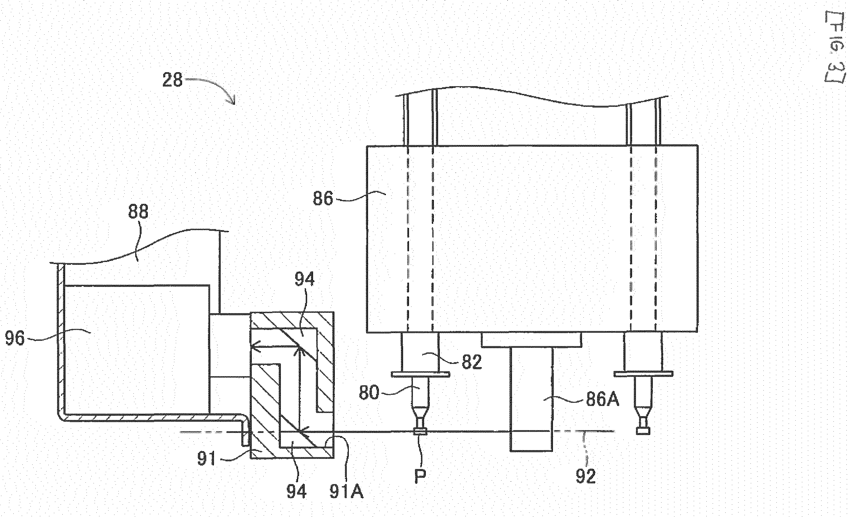

An embodiment of the invention will be described below with reference to the drawings. First, an electronic component mounting device (hereinafter, abbreviated as a "mounting apparatus" in some cases) will be described as an example of an apparatus to which a communication system of this application is applied. (Configuration of electronic component mounting device 10) Fig. 1 is a perspective view of a mounting apparatus 10 from which a part of exterior components are removed. The mounting device 10 is a mounting apparatus that includes one system base 12 and two electronic component mounting machines (hereinafter, abbreviated as "mounting machines" in some cases) 16 arranged so as to line up on the system base 12 and mounts an electronic component P (see Fig. 3) on a circuit board. Meanwhile, in the following description, a direction in which the mounting machines 16 are arranged side by side as shown in Fig. 1 is referred to as an X-axis direction, a direction that is parallel to a horizontal direction so as to be orthogonal to the X-axis direction is referred to as a Y-axis direction, and a direction that is orthogonal to the X-axis direction and the Y-axis direction is referred to as a vertical direction.

The mounting machine 16 includes a mounting machine body 24 that includes a frame portion 20 and a beam portion 22 mounted on the frame portion 20, a conveyance device 26 that conveys a circuit board in the X-axis direction and lifts up and clamps the circuit board at a set position, a mounting head 28 that performs mounting work on the circuit board fixed by the conveyance device 26, a moving device 30 that is provided on the beam portion 22 and moves the mounting head 28 in the X-axis direction and the Y-axis direction, and an electronic component supply device (hereinafter, abbreviated as a "supply device" in some cases) 32 that is connected to a front portion of the frame portion 20 and supplies electronic components P. Further, the mounting machine 16 includes an operation panel 18 that is provided on the outside of the beam portion 22. The operation panel 18 is a touch screen-type display device, and can receive operations, such as the starting and stopping, of work for mounting the electronic component P and can display information about the work.

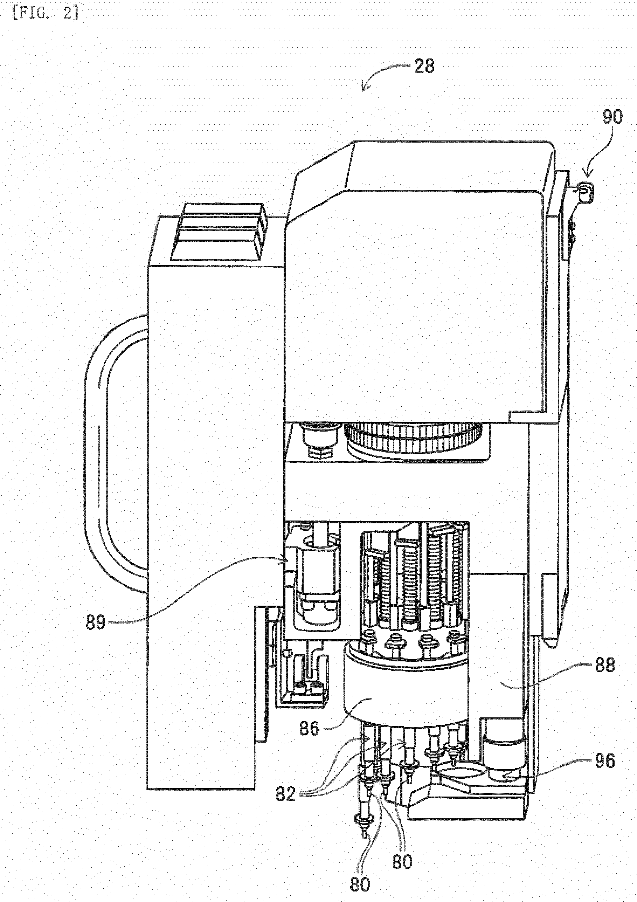

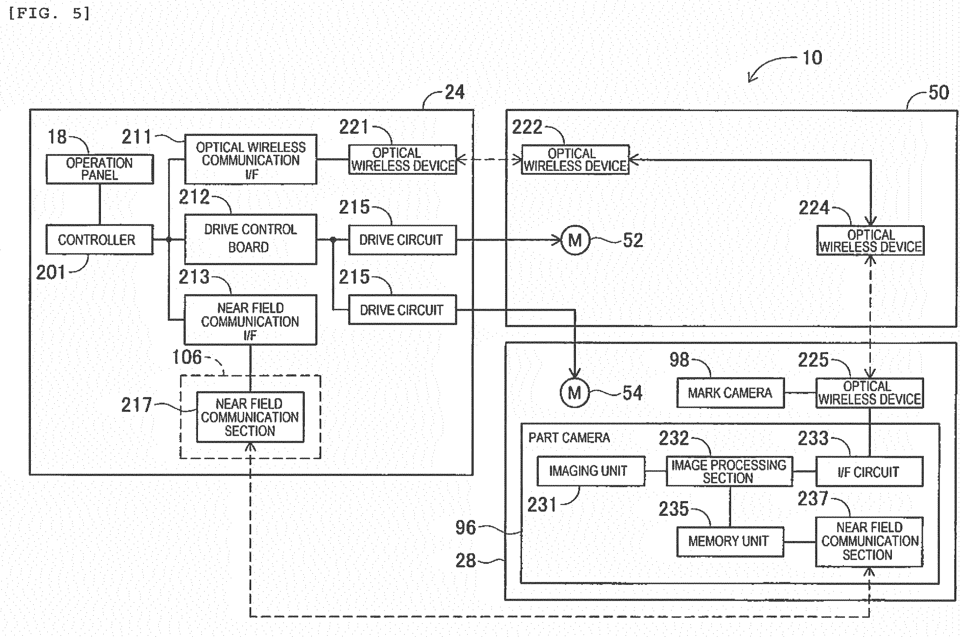

The conveyance device 26 is a so-called double-conveyor type device that includes two conveyor units 40 and 42. The respective conveyor units 40 and 42 are provided substantially in the middle of the frame portion 20 in the Y-axis direction, and are arranged side by side in the Y-axis direction. Further, the conveyor units 40 and 42 are fixed so that the conveying directions of the conveyor units 40 and 42 are parallel to the X-axis direction. Each of the conveyor units 40 and 42 conveys and fixes a circuit board. The moving device 30 is a so-called XY robot-type moving device, and drives an electromagnetic motor 52 (see Fig. 5), which is built in a slider 50, to allow the slider 50 to slide in the Y-axis direction along a guide rail (not shown) that is held on the beam portion 22. The slider 50 is provided with a guide rail (not shown) parallel to the X-axis direction, and the mounting head 28 is mounted on the guide rail through a guide block 90 (see Fig. 2). When an electromagnetic motor 54 (see Fig. 5), which is built in the mounting head 28, is driven, the mounting head 28 is moved in the X-axis direction along the guide rail of the slider 50. The moving device 30 can move the mounting head 28 to an arbitrary position on the frame portion 20 by driving the two electromagnetic motors 52 and 54. The electromagnetic motors 52 and 54 are, for example, linear motors.

Next, the mounting head 28 will be described. Fig. 2 is a perspective view of the mounting head 28 that is separated from the guide rail of the slider 50, and the guide block 90 is provided on the side surface of the mounting head 28 facing the slider 50. As shown in Fig. 2, the mounting head 28 includes multiple sets (in this embodiment, 12 sets) of a suction nozzle 80, which sucks the electronic component P (see Fig. 3), and a mounting unit 82 that holds the suction nozzle 80 at a distal end portion thereof. Each of the suction nozzles 80 communicates with a positive/negative pressure supply device (not shown) through a negative-pressure air passage and a positive-pressure air passage, and is adapted to suck and hold the electronic component P with negative pressure and release the held electronic component P by the supply of slightly positive pressure. The mounting unit 82 is formed substantially in the shape of a bar, and is held so that an axial direction of the mounting unit 82 is parallel to the vertical direction of the mounting device 10. The mounting units 82 are provided on an outer peripheral portion of a substantially cylindrical unit holding body 86 at regular intervals.

The unit holding body 86 is rotatably supported by a head body 88 of the mounting head 28, and is intermittently rotated together with the mounting units 82 by a holding body rotating device (not shown) . The mounting units 82 are adapted to move in the vertical direction with the intermittent rotation of the unit holding body 86. In detail, each mounting unit 82 moves to the lowermost end at a stop position (hereinafter, referred to as a "mounting station") where the mounting unit is farthest from the head body 88. The suction nozzle 80 sucks and holds the electronic component P at the mounting station or mounts the held electronic component P on a circuit board. Further, each mounting unit 82 moves to the uppermost end at a stop position (hereinafter, referred to as an "imaging station") where the mounting unit is closest to the head body 88 and at four stop positions of which two stop positions are present on each of both sides of the imaging station in a rotational direction. That is, the mounting units 82 present at a total of five stop positions, which include the imaging station and four stop positions present on both sides of the imaging station, move to the uppermost end. Furthermore, the mounting head 28 includes unit rotating devices (not shown) that rotate the mounting units 82 about the axes of the mounting units 82, respectively, and is adapted to be capable of changing the holding postures of the electronic components P that are sucked and held by the respective mounting units 82. Moreover, the mounting head 28 includes a unit lifting and lowering device 89 that individually lifts and lowers the mounting units 82, and moves the mounting unit 82 to an arbitrary position in the vertical direction.

A lower end portion of the head body 88 extends downward further than a distal end portion of the suction nozzle 80 that is positioned at the mounting station. A part camera 96 is provided at a portion of the head body 88 that faces the distal end portion of the suction nozzle 80. The part camera 96 images the electronic component P that is held by the suction nozzle 80 positioned at the imaging station. Further, the extending distal end portion of the head body 88 is formed so as to be bent toward the suction nozzle 80. A mark camera 98 (see Fig. 5) is provided at the bent portion of the head body 88. The mark camera 98 is fixed so as to face the lower side, and images a reference position mark of a circuit board, an ID mark used to identify a circuit board, the mounting state of the electronic component P, or the like.

Fig. 3 is a partial enlarged view of the mounting head 28 that holds the electronic component P. As shown in Fig. 3, a cylindrical reflector 86A, which can reflect light, is fixed to the lower end portion of the unit holding body 86. A box-shaped bracket 91 is fixed to a portion of the head body 88 where the part camera 96 faces the suction nozzle 80. A light source (not shown), such as a LED, which emits light toward the reflector 86A, is provided in the bracket 91. Light, which is emitted from the light source, is reflected by the reflector 86A and is incident on the bracket 91 from an incident portion 91A. When the suction nozzle 80 of the mounting head 28 moves to the uppermost end at the imaging station, the reflector 86A, the electronic component P sucked by the suction nozzle 80, and the incident portion 91A line up on a virtual straight line 92. Two prisms 94 are provided in the bracket 91. As shown in Fig. 3 by an arrow, light reflected by the reflector 86A passes through an outer peripheral edge of the electronic component P and the incident portion 91A, is reflected by the prisms 94, and is incident on the part camera 96. The part camera 96 acquires the two-dimensional image of the electronic component P that is sucked by the suction nozzle 80. Meanwhile, it is preferable that the bracket 91 is provided with a shield plate preventing light from being directly emitted to the electronic component P from the light source.

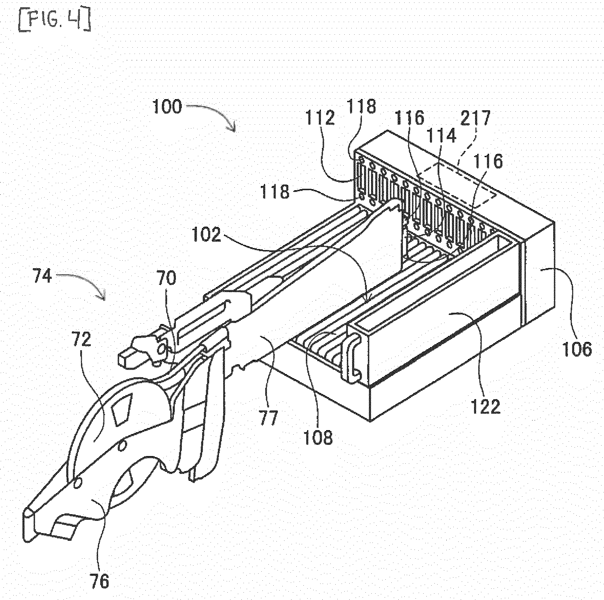

Next, the supply device 32 shown in Fig. 1 will be described. The supply device 32 is a feeder-type supply device, and includes a plurality of tape feeders 74 and feeder bodies 77 (see Fig. 4). The plurality of tape feeders 74 store tape-shaped components 70 (see Fig. 4), which are obtained by taping electronic components P, while the tape-shaped components 70 are wound on reels 72. The feeder bodies 77 feed the tape-shaped components 70 that are stored in the plurality of tape feeders 74. The supply device 32 sequentially supplies the electronic components P to a supply position from the tape-shaped component 70. In a perspective view of Fig. 4, a part of exterior components are removed from the tape feeder 74. As shown in Fig. 4, each tape feeder 74 includes a reel holder 76 that holds the reel 72 on which the tape-shaped component 70 is wound, and the feeder body 77 that allows the tape-shaped component 70 unwound from the reel 72 to extend on an upper end face thereof. When a sprocket (not shown) built in the feeder body 77 is rotated, the tape-shaped component 70 is fed on the upper end face of the feeder body 77 in a direction where the tape-shaped component 70 becomes distant from the reel 72. The electronic components P are sequentially released from the tape-shaped component 70 at the supply position, which is present at the distal end portion of the feeder body 77, by a peeling device (not illustrated), and are taken out by the suction nozzles 80.

Further, the tape feeder 74 is detachably mounted on a feeder support table 100 that is provided at the front end portion of the frame portion 20 (see Fig. 1). The feeder support table 100 includes a slot portion 102 that is formed on the upper surface of the frame portion 20 and a connecting portion 106 that stands at the rear end portion of the slot portion 102 (close to the conveyance device 26). A plurality of slots 108 are formed on the slot portion 102 in the Y-axis direction. A lower edge portion of the feeder body 77 slides on each of the plurality of slots 108 and the tape feeder 74 is connected to the connecting portion 106. A connector 114 and a pair of positioning pins 116, which are positioned on both sides of the connector 114 in the vertical direction, are provided on the surface of the feeder body 77 facing the connecting portion 106. Meanwhile, a connector 112 to which the connector 114 is connected and a pair of fitting holes 118 into which the positioning pins 116 are fitted are formed at the connecting portion 106 so as to correspond to each of the slots 108. Power is supplied to the tape feeder 74 from the feeder support table 100 through the connectors 112 and 114 connected to each other, and the tape feeder 74 transmits necessary control signals (a component request signal, a component-supply-completion signal, and the like) and management information such as the IDs of each tape feeder 74.

A discard box 122 into which the electronic components P are discarded is mounted on the feeder support table 100. The discard box 122 is used to collect electronic components P that are not mounted on a circuit board due to the reason that electronic components P are not sucked in a normal posture by the suction nozzles 80, or the like. Similar to the tape feeder 74, the discard box 122 is provided with a connector and positioning pins (not shown) that are connected to the connecting portion 106. The discard box 122 transmits management information, such as the ID used to identify the discard box 122, through the connector 112. Meanwhile, the discard box 122 may be provided for each type of electronic components P.

### (Communication system applied to mounting apparatus 10)

As shown in Fig. 5, the mounting device 10 according to this embodiment is adapted to use optical wireless communication for the transmission of data between a controller 201 and a movable portion (the slider 50 and the mounting head 28) of the mounting device 10. Meanwhile, Fig. 5 shows the schematic configuration of the mounting device 10, and the respective devices of the mounting apparatus 10 are appropriately omitted in Fig. 5. Further, the configuration of the communication system shown in Fig. 5 is exemplary, and is appropriately modified according to the types and the number of the devices included in the mounting device 10. Furthermore, the communication system of this application is a system that can be applied to automatic machines and the like operating in various manufacturing lines other than the electronic component mounting device exemplified as the mounting device 10.

As shown in Fig. 5, the mounting device 10 includes the controller 201 mainly configured by a computer which includes a CPU and the like, an optical wireless communication I/F (hereinafter, referred to as an "optical wireless I/F") 211, a drive control board 212, and a near field communication I/F (hereinafter, referred to as a "near field communication I/F) 213 that are built in the mounting machine body 24. The optical wireless I/F 211 processes the transmission of data to/from the respective cameras 96 and 98 of the mounting head 28. The drive control board 212 is a board that controls operation instructions to the electromagnetic motor 52 of the slider 50 and the electromagnetic motor 54 of the mounting head 28 and the input/output of information and the like fed back from the electromagnetic motors 52 and 54 in real time. The drive control board 212 controls drive circuits 215, which are connected to the electromagnetic motors 52 and 54 by cables, to drive the respective motors 52 and 54. The near field communication I/F 213 controls the start and the like of data transmission of a near field communication section (hereinafter, referred to as a "communication section") 217 that is connected to the near field communication I/F 213 by a cable.

The optical wireless I/F 211 is connected to an optical wireless device 221 that is built in the mounting machine body 24 . The slider 50 is provided with an optical wireless device 222 that faces the optical wireless device 221. The optical wireless device 222 is fixed to the slider 50 so that, for example, an optical axis of the optical wireless device 222 parallel to the Y-axis direction corresponds to that of the optical wireless device 221 of the mounting machine body 24. Input/output data of the optical wireless I/F 211 is transmitted to the optical wireless devices 221 and 222 by optical wireless communication using, for example, an LED and the like. In the optical wireless communication between the optical wireless devices 221 and 222, data is transmitted and received as multiplexed data, for example, time division multiplex (TDM) frame data.

The optical wireless device 222 is connected to an optical wireless device 224 that is built in the slider 50. The mounting head 28 is provided with an optical wireless device 225 that faces the optical wireless device 224. The optical wireless device 225 is fixed to the mounting head 28 so that an optical axis of the optical wireless device 225 parallel to the X-axis direction corresponds to that of the optical wireless device 224 of the slider 50. Input/output data of the optical wireless I/F 211 is transmitted to the optical wireless devices 224 and 225 by optical wireless communication.

The part camera 96 of the mounting head 28 includes an imaging unit 231, an image processing section 232, an I/F circuit 233, a memory unit 235, and a near field communication section (hereinafter, referred to as a "communication section") 237. Meanwhile, since the mark camera 98 has the same configuration as the part camera 96, the internal configuration and the detailed description thereof will be appropriately omitted. The imaging unit 231 is an imaging element, such as a CMOS sensor or a CCD sensor. The imaging unit 231 outputs obtained image data to the image processing section 232. The image processing section 232 performs various kinds of image processing for extracting necessary information from the image data that is input from the imaging unit 231. The image processing section 232 controls the I/F circuit 233 and outputs processing result data to the optical wireless device 225. The optical wireless device 225 transmits processing results to the optical wireless device 221 provided in the apparatus body through the optical wireless devices 224 and 222 of the slider 50.

Here, the image processing section 232 performs edge detection processing, gamma correction, contour emphasis, and the like as various kinds of image processing for extracting necessary information. The image processing section 232 calculates, for example, a value, which is used to correct the amount of a positional deviation of an electronic component P to be sucked by the suction nozzle 80, from edge detection processing results. Further, similar to the part camera 96, the mark camera 98 has an image processing function to extract necessary information and detects the reference position mark of a circuit board to calculate a value that is used to correct the amount of a positional deviation of the circuit board. The part camera 96 transmits a position correction value to the controller 201 through the optical wireless device 225. The controller 201 moves the mounting head 28 to a position above the circuit board conveyed by the conveyance device 26 (see Fig. 1), and corrects an error between holding positions of the circuit board and the electronic component P on the basis of the position correction values received from the respective cameras 96 and 98. The controller 201 mounts the electronic component P on the circuit board after correcting the holding position of the electronic component by moving or rotating the suction nozzle 80 according to the error of the holding position. Meanwhile, although not shown in Fig. 5, the controller 201 performs the correction of the holding position of the above-mentioned suction nozzle 80 by controlling the driving of servo motors or the like of the mounting unit 82 and the unit lifting and lowering device 89 (see Fig. 2) of the mounting head 28. The control data is transmitted through optical wireless communication (the optical wireless device 221 and the like).

Meanwhile, the image processing section 232 compares, for example, the edge detection processing results with preset dimensions of each electronic component P and determines whether or not the electronic component P is sucked normally by the suction nozzle 80. Here, a reason why the electronic component P is not held normally by the suction nozzle 80 includes various cases, such as a case in which the orientation of the electronic component P held by the suction nozzle 80 is wrong and a case in which the electronic component P is not sucked by the suction nozzle 80. For this reason, a user of the mounting device 10 needs to confirm an actual image that is taken when the electronic component is sucked and held abnormally. However, the amount of actual image data of the distal end portion or the like of the suction nozzle 80 becomes larger than the amount of processing result data such as position correction values transmitted when the electronic component is sucked and held normally. That is, in order to transmit actual image data through an optical wireless communication line that is normally used, it is necessary to increase the data transmission speed of the communication line according to the transmission of a large amount of data that temporarily occurs in a working process such as a case in which the electronic component is sucked and held abnormally. Accordingly, in the mounting device 10 according to this embodiment, actual image data is transmitted between each of the cameras 96 and 98 and the apparatus body through near field communication that is separate from optical wireless communication when abnormality, such as a case in which the electronic component P is not held normally, is detected.

The image processing section 232 performs image processing and performs processing for storing actual image data, which is input from the imaging unit 231, in the memory unit 235. When the controller 201 receives processing result data representing that the electronic component P is not held normally from the image processing section 232, the controller 201 moves the mounting head 28 to a position above the discard box 122 (see Fig. 4) and performs processing for releasing the electronic component P from the suction nozzle 80 to discard the electronic component P. In this case, the mounting head 28 transmits the actual image data, which are stored in the memory unit 235, to the communication section 217 provided in the apparatus body from the communication section 237 through near field communication. The near field communication between the communication sections 217 and 237 is performed using a communication technique such as TransferJET (registered trademark). Communication speed between the communication sections 217 and 237 is, for example, 350 Mbps and is higher than the speed of optical wireless communication. In other words, wireless devices (the optical wireless devices 221, 222, 224, and 225) of which communication speed is lower than the communication speed of the near field communication sections 217 and 237 can be used for optical wireless communication that normally transmits processing result data (position correction values and the like) of the respective cameras 96 and 98. Accordingly, since the transmission of a large amount of data, which temporarily occurs in a working process when the electronic component is sucked and held abnormally, is performed through a separate line, the data transmission speed of a normal communication line can be reduced.

Further, as shown in Fig. 4, the communication section 217 provided in the apparatus body is provided on the connecting portion 106 of the feeder support table 100. The communication section 217 is provided at a position facing the communication section 237 of the part camera 96 when the controller 201 moves the mounting head 28 to the discard box 122 to discard the electronic component P. The mounting head 28 approaches the connecting portion 106 and the discard box 122 with a distance of, for example, about several centimeters therebetween. The actual image data, which is received from the communication section 237 through near field communication by the communication section 217, is input to the controller 201 from the near field communication I/F 213. Accordingly, the controller 201 can process an operation for discarding the electronic component P in parallel with processing for receiving the actual image data. The controller 201 performs mounting work on the basis of a control program and the like. However, since the controller 201 is adapted to simultaneously perform existing processing for discarding the electronic component P and the transmission of the actual image data, the control program is easily changed. Furthermore, since time required to transmit actual image data does not need to be separately reserved, production efficiency is barely affected. That is, the data transmission speed of a normal communication line is also reduced without the reduction of production efficiency even when image data is transmitted. Moreover, since the controller 201 can transmit data through optical wireless communication even when the controller 201 performs near field communication, it is possible to remove the influence of the transmission of actual image data on the transmission of normal processing result data.

The controller 201 transmits the received actual image data to a control device (not shown) that performs the centralized management of, for example, a plurality of mounting machines 16; and processing for storing the actual image data in an external storage device is performed by the control device. The controller 201 performs processing for transmitting other information (for example, time information, the type of the electronic component P, ID of the discard box 122, identification information of the suction nozzle 80, ID of the circuit board, and the like) together when the actual image data is stored. Further, when poor mounting occurs or after poor mounting occurs, a user can visually confirm the actual image data, which is stored in the external storage device, on a monitor of the control device or the like. Alternatively, the controller 201 may be set to transmit the actual image data, which is received through, for example, a network, to a vendor and the like. Accordingly, a user can quickly and accurately cope with poor mounting with reference to an expert's determination.

Furthermore, the communication sections 217 and 237 can perform bidirectional near field communication. When, for example, the type of the electronic component P to be held by the suction nozzle 80 is changed, the controller 201 transmits setting data related with the image processing of the part camera 96, which corresponds to a changed electronic component P, by the communication sections 217 and 237. The setting data is setting values of the size and the like of an area, which corresponds to, for example, the shape or size of the electronic component P and is to be subjected to image processing. There is a high possibility that the amount of the setting data may be larger than the amount of processing result data, such as position correction values output from the image processing section 232. For this reason, when the type of the electronic component P is changed, the controller 201 moves the mounting head 28 to the position of the communication section 217 of the connecting portion 106 (see Fig. 4) according to processing or the like for changing the tape feeder 74 to be driven and transmits the setting data to the communication section 237. Accordingly, it is not necessary to increase the data transmission speed of a normal communication line according to the transmission of a large amount of data that temporarily occurs in a working process such as a case in which the electronic component P is changed. Meanwhile, the controller 201 may transmit the actual image data from the mounting head 28 when transmitting the setting data through the near field communication.

According to the above-mentioned embodiment, the following effect will be obtained. (1) The mounting device 10 includes the part camera 96 and the mark camera 98 that are provided on the mounting head 28. The part camera 96 images the electronic component P sucked by the suction nozzle 80, and the mark camera 98 images the reference position mark of the circuit board or the like. Each of the cameras 96 and 98 has an image processing function to process the taken image data. The mounting device 10 includes two types of communication means for transmitting the data of the respective cameras 96 and 98. Each of the cameras 96 and 98 transmits the processing result data of whether or not the electronic component P is sucked normally by the suction nozzle 80 to the controller 201 as the result of image processing through the optical wireless communication that is performed through the optical wireless devices 221, 222, 224, and 225. When it is detected that the electronic component P is not held normally by the suction nozzle 80 on the basis of the received processing result data, the controller 201 performs control for transmitting the actual image data to each of the cameras 96 and 98. Each of the cameras 96 and 98 transmits the actual image data to the controller 201 through the near field communication that is performed through the communication sections 217 and 237. The amount of processing result data of image processing, which are normally transmitted, is smaller than the amount of actual image data that is necessary when the electronic component is sucked and held abnormally. For this reason, wireless devices (the optical wireless device 221, and the like) of which communication speed is lower than the communication speed of the wireless device used for near field communication can be used for optical wireless communication. Accordingly, since the transmission of a large amount of data that temporarily occurs in a working process such as a case in which the electronic component is sucked and held abnormally is performed through a separate line, the data transmission speed of a normal communication line can be reduced. That is, it is possible to improve transmission efficiency by optimizing the communication line according to the amount of data to be transmitted. Consequently, since low-speed and inexpensive wireless communication devices are used, it is possible to reduce manufacturing costs.
(2) Communication between the communication sections 217 and 237 is performed as near field communication of which speed is higher than the speed of the optical wireless communication (the communication between the optical wireless devices 221, 222, 224, and 225), by using a communication technique such as TransferJET (registered trademark). Accordingly, it is possible to reduce the influence of the processing, which transmits actual image data, on mounting work by shortening transmission time.
(3) Since the controller 201 transmits actual image data through near field communication at a timing at which it is detected that the electronic component P is not held normally by the suction nozzle 80 on the basis of the processing result data transmitted from the image processing section 232 of the part camera 96, data is efficiently transmitted.
(4) When the type of the electronic component P to be held by the suction nozzle 80 is changed, the controller 201 transmits the setting data of the part camera 96, which corresponds to a changed electronic component P, by the communication sections 217 and 237. Accordingly, since the transmission of a large amount of data that temporarily occurs in a working process such as a case in which the electronic component P is changed is performed through a separate line, the data transmission speed of a normal communication line can be reduced.
(5) In the mounting device 10, the communication section 217 provided in the near field communication apparatus body is provided in the connecting portion 106 to which the discard box 122 in which poorly mounted electronic components P are stored is connected. Further, the communication section 217 is provided at a position facing the communication section 237 of the part camera 96 when the electronic component P is discarded. Accordingly, since the communication lines of the communication sections 217 and 237 are more reliably established when the communication sections 217 and 237 perform near field communication, actual image data is stably transmitted.
(6) The controller 201 can process an operation for discarding the electronic component P in parallel with processing for receiving the actual image data. Accordingly, the data transmission speed of a normal communication line is also reduced without the reduction of production efficiency even when the actual image data is transmitted.
(7) Since control information, in which the controller 201 of the mounting device 10 controls the mounting unit 82 and the unit lifting and lowering device 89 of the mounting head 28, is transmitted through optical wireless communication, the communication line is optimized according to the amount of data to be transmitted.

Meanwhile, it goes without saying that the invention is not limited to the above-mentioned embodiment and may be improved and modified in various ways without departing from the scope of the invention. For example, optical wireless communication has been exemplified as a normal communication means in the above-mentioned embodiment. However, this application is not limited thereto; and wireless communication using various electromagnetic waves other than infrared light, visible light, and the like or wired communication (for example, communication standards based on RS485, and the like) may be applied. Even in this case, it is preferable that, for example, the communication speed of wired communication is lower than the speed of near field communication (for example, about 10 Mbps). Accordingly, it is possible to improve transmission efficiency and to reduce manufacturing costs by optimizing the communication line according to the amount of data to be transmitted.

In addition, since the structure of the sheath or the like of the cable is restricted when the impedance of a communication cable used for wired communication is reduced or the impedance of the communication cable is adjusted, the elasticity of a cable capable of being used for general high-speed communication is low. When a cable having low elasticity is used as a cable, which connects the apparatus body of the above-mentioned mounting device 10 to the movable mounting head 28, in order to increase data transmission speed, the degree of freedom of wiring in the mounting apparatus 10 is restricted and the possibility of the breaking of an internal signal line is increased. In contrast, according to this application, the data transmission speed of a normal communication line is reduced through the optimization of the communication line according to the amount of data to be transmitted. Accordingly, it is possible to use a cable that has high elasticity and low data transmission speed. As a result, since the degree of freedom of wiring of a cable, which connects a fixed portion to a movable portion, is improved, it is possible to reduce the possibility of breaking and to improve the reliability of normal data transmission.

Further, communication using an electric field coupling system may be used as the normal communication means. For example, the guide rail of the slider 50, which is parallel to the X-axis direction, and a flat-plate electrode, which faces the guide block 90 of the mounting head 28, may be provided to transmit data by the change of capacitance.

Furthermore, the near field communication of the above-mentioned embodiment is not limited to TransferJET (registered trademark); and communication means suitable for other communications standards, such as standards of infrared light communication (Giga-IR), Bluetooth (registered trademark), standards (IEEE802.11) of wireless LAN, Zigbee (registered trademark), and the like may be used. Moreover, the communication between the communication sections 217 and 237 is not limited to near field communication, and other wireless communication systems or wired communication may be used. Further, the communication between the communication sections 217 and 237 may be communication of which speed is lower than the speed of the optical wireless communication (the communication between the optical wireless devices 221, 222, 224, and 225). That is, the communication sections 217 and 237 as second communication means may be formed as separate lines other than the optical wireless communication (first communication means) that transmits the processing result data of image processing. Even in this configuration, transmission efficiency is improved through the optimization of the communication line according to the amount of data to be transmitted.

Furthermore, the electronic component mounting device 10, which mounts an electronic component P on a circuit board, has been described in the above-mentioned embodiment. However, the invention is not limited thereto and can be applied to automatic machines and the like operating in various other manufacturing lines. For example, the invention may be applied to an automatic machine that assembles a secondary cell (a solar cell, a fuel cell, or the like) and the like. In this case, for example, an assembly component, which is held by a movable portion, such as a mounting head or an arm, is used as a workpiece that is imaged by the imaging unit 231, and the invention may be applied to a communication system that transmits image data thereof and processing result data. Further, the automatic machine is not limited to a machine that performs mounting or assembling, but the invention may be applied to, for example, a machine tool that performs cutting and the like. In this case, a workpiece or the like, which is to be cut, may be used as an object to be imaged.

Furthermore, the configuration of the mounting device 10 according to the embodiment is exemplary and may be appropriately modified. For example, the positions of the communication sections 217 and 237 of the mounting device 10 and a timing in which the near field communication is performed are exemplary, and may be appropriately changed. For example, each of the mounting machines 16 may include multiple sets of the mounting head 28 and the moving device 30.

Meanwhile, a correspondence relationship with terms used in claims is as follows: The electronic component mounting device 10 corresponds to an example of an electronic component mounting device, the mounting head 28 corresponds to an example of a movable portion, the part camera 96 and the mark camera 98 correspond to an example of an imaging device, the discard box 122 and the connecting portion 106 correspond to an example of a storage unit, the controller 201 corresponds to an example of a control unit, the optical wireless devices 221, 222, 224, and 225 correspond to an example of first communication means, the communication sections 217 and 237 correspond to an example of second communication means for performing near field communication, the communication section 217 corresponds to an example of a receiving unit, the electronic component P corresponds to an example of a workpiece and an electronic component, and the position correction value corresponds to an example of processing result data.

### Reference Signs List

10: ELECTRONIC COMPONENT MOUNTING DEVICE, 28: MOUNTING HEAD, 96: PART CAMERA, 98: MARK CAMERA, 106: CONNECTING PORTION, 122: DISCARD BOX, 201: CONTROLLER, 221, 222, 224, 225: OPTICAL WIRELESS DEVICE, 217, 237: communication section, P: ELECTRONIC COMPONENT

## Claims

1. A communication system comprising:
a movable portion (50, 28) configured to hold and move a workpiece (P); and
an imaging device (96, 98) that is integrally provided on the movable portion (50, 28),
the imaging device (96, 98) is configured to perform image processing for extracting necessary information from image data of a state in which the movable portion (50, 28) holds the workpiece (P), and
the communication system further comprises:
a control unit (201) configured to drive the movable portion (50, 28) on the basis of processing result data of the image processing performed by the imaging device (96, 98);
first communication means (221, 222, 224, 225) configured for transmitting the processing result data to the control unit (201) from the imaging device (96, 98); and
second communication means (217, 237) other than the first communication means (221, 222, 224, 225),
**characterised in that**
the control unit (201) is configured to transmit the image data from the imaging device (96, 98) on the basis of the processing result data by the second communication means (217, 237), and
wherein the communication system is configured such that, when it is determined that the workpiece (P) is not held normally by the movable portion (50, 28) on the basis of the processing result data, the control unit (201) allows the second communication means (217, 237) to transmit the image data.

2. The communication system according to claim 1,
wherein the second communication means (217, 237) is a communication device for transmitting data, of which the amount is larger than the amount of the processing result data which the first communication means (221, 222, 224, 225) is configured to transmit, through near field communication.

3. The communication system according to claim 1 or 2,
wherein the second communication means (217, 237) is a communication device that is configured to perform bidirectional near field communication, and
when a type of the workpiece (P) to be held by the movable portion (50, 28) is changed, the control unit (201) transmits setting data related with the image processing of the imaging device (96, 98), which corresponds to a changed workpiece (P), to the imaging device (96, 98) from the control unit (201) by the second communication means (217, 237).

4. The communication system according to any one of claims 1 to 3,
wherein the control unit (201) includes a storing unit (122, 106) configured to discard the workpiece (P) when it is determined that the workpiece (P) is not held normally by the movable portion (50, 28),
the second communication means (217, 237) includes a receiving unit (217) that is provided in the storing unit (122, 106) and faces the imaging device (96, 98) when the control unit (201) moves the movable portion (50, 28) to the storing unit (122, 106) to discard the workpiece (P).

5. The communication system according to claim 4,
wherein the control unit (201) is configured to perform processing for discarding the workpiece (P) by the movable portion (50, 28) in parallel with processing for transmitting the image data to the receiving unit (217) from the imaging device (96, 98) by the second communication means (217, 237).

6. The communication system according to any one of claims 1 to 5,
wherein the first communication means (221, 222, 224, 225) is a communication device that is configured to perform bidirectional multiplexed optical wireless communication, and the control unit (201) is configured to transmit control data, which drive the movable portion (50, 28), by the first communication means (221, 222, 224, 225).

7. An electronic component mounting device comprising the communication system according to any one of claims 1 to 6, the device configured to transmit data related with work for mounting an electronic component, which is held as the workpiece (P) by the movable portion (50, 28), on a circuit board by the communication system.

## Patentansprüche

1. Kommunikationssystem, das umfasst:
einen beweglichen Abschnitt (50, 28), der zum Halten und Bewegen eines Werkstücks (P) eingerichtet ist; sowie
eine Bilderzeugungsvorrichtung (96, 98), die integral an dem beweglichen Abschnitt (50, 28) angeordnet ist,
wobei die Bilderzeugungsvorrichtung (96, 98) so eingerichtet ist, dass sie Bildverarbeitung zum Extrahieren notwendiger Informationen eines Zustandes, in dem der bewegliche Abschnitt (50, 28) das Werkstück (P) hält, aus Bilddaten durchführt und
das Kommunikationssystem des Weiteren umfasst:
eine Steuerungs-Einheit (201), die so eingerichtet ist, dass sie den beweglichen Abschnitt (50, 28) auf Basis von Verarbeitungsergebnis-Daten der von der Bilderzeugungsvorrichtung (96, 98) durchgeführten Bildverarbeitung ansteuert;
erste Kommunikationseinrichtungen (221, 222, 224, 225), die zum Übertragen der Verarbeitungsergebnis-Daten von der Bilderzeugungsvorrichtung (96, 98) zu der Steuerungs-Einheit (201) eingerichtet sind; und
zweite Kommunikationseinrichtungen (217, 237), die sich von den ersten Kommunikationseinrichtungen (221, 222, 224, 225) unterscheiden,
**dadurch gekennzeichnet, dass**
die Steuerungs-Einheit (201) so eingerichtet ist, dass sie die Bilddaten von der Bilderzeugungsvorrichtung (96, 98) auf Basis der Verarbeitungsergebnis-Daten über die zweiten Kommunikationseinrichtungen (217, 237) überträgt, und
wobei das Kommunikationssystem so eingerichtet ist, dass, wenn auf Basis der Verarbeitungsergebnis-Daten festgestellt wird, dass das Werkstück (P) nicht normal von dem beweglichen Abschnitt (50, 28) gehalten wird, die Steuerungs-Einheit (201) zulässt, dass die zweiten Kommunikationseinrichtungen (217, 237) die Bilddaten übertragen.

2. Kommunikationssystem nach Anspruch 1,
wobei die zweiten Kommunikationseinrichtungen (217, 237) eine Kommunikationsvorrichtung sind, mit der Daten, deren Menge größer ist als die Menge der Verarbeitungsergebnis-Daten, für deren Übertragung die ersten Kommunikationseinrichtungen (221, 222, 224, 225) eingerichtet sind, mittels Nahfeldkommunikation übertragen werden.

3. Kommunikationssystem nach Anspruch 1 oder 2,
wobei die zweiten Kommunikationseinrichtungen (217, 237) eine Kommunikationsvorrichtung sind, die zum Durchführen bidirektionaler Nahfeldkommunikation eingerichtet ist, und
wenn ein Typ des durch den beweglichen Abschnitt (50, 28) zu haltenden Werkstücks (P) geändert wird, die Steuerungs-Einheit (201) Einstellungs-Daten, die mit der Bildverarbeitung der Bilderzeugungsvorrichtung (96, 98) zusammenhängen, die einem geänderten Werkstück (P) entspricht, von der Steuerungs-Einheit (201) über die zweiten Kommunikationseinrichtungen (217, 237) zu der Bilderzeugungsvorrichtung (96, 98) überträgt.

4. Kommunikationssystem nach einem der Ansprüche 1 bis 3,
wobei die Steuerungs-Einheit (201) eine Speicher-Einheit (122, 106) enthält, die so eingerichtet ist, dass sie das Werkstück (P) aussondert, wenn festgestellt wird, dass das Werkstück (P) nicht normal von dem beweglichen Abschnitt (50, 28) gehalten wird,
die zweiten Kommunikationseinrichtungen (217, 237) eine Empfangs-Einheit (217) einschließen, die in der Speicher-Einheit (122, 106) vorhanden ist und der Bilderzeugungsvorrichtung (96, 98) zugewandt ist, wenn die Steuerungs-Einheit (201) den beweglichen Abschnitt (50, 28) zu der Speicher-Einheit (122, 106) bewegt, um das Werkstück (P) auszusondern.

5. Kommunikationssystem nach Anspruch 4,
wobei die Steuerungs-Einheit (201) so eingerichtet ist, dass sie Verarbeitung zum Aussondern des Werkstücks (P) durch den beweglichen Abschnitt (50, 28) parallel zu Verarbeitung zum Übertragen der Bilddaten von der Bilderzeugungsvorrichtung (96, 98) zu der Empfangseinheit (217) mittels der zweiten Kommunikationseinrichtungen (217, 237) durchführt.

6. Kommunikationssystem nach einem der Ansprüche 1 bis 5,
wobei die ersten Kommunikationseinrichtungen (221, 222, 224, 225) eine Kommunikationsvorrichtung sind, die zum Durchführen bidirektionaler optischer Drahtlos-Multiplex-Kommunikation eingerichtet ist, und
die Steuerungs-Einheit (201) so eingerichtet ist, dass sie Steuerungs-Daten, die den beweglichen Abschnitt (50, 28) ansteuern, über die ersten Kommunikationseinrichtungen (221, 222, 224, 225) überträgt.

7. Vorrichtung zum Montieren elektronischer Bauteile, die das Kommunikationssystem nach einem der Ansprüche 1 bis 6 umfasst, wobei die Vorrichtung so eingerichtet ist, dass sie Daten, die mit Arbeit zum Montieren eines elektronischen Bauteils, das als das Werkstück (P) durch den beweglichen Abschnitt (50, 28) gehalten wird, auf einer Leiterplatte zusammenhängen, über das Kommunikationssystem überträgt.

## Revendications

1. Système de communication comprenant :
une partie mobile (50, 28) configurée pour maintenir et déplacer une pièce à travailler (P) ; et
un dispositif de formation d'image (96, 98) situé sur la partie mobile (50, 28) et faisant corps avec elle,
le dispositif de formation d'image (96, 98) est configuré pour réaliser un traitement d'image en vue d'extraire des informations nécessaires de données d'image concernant un état dans lequel la partie mobile (50, 28) maintient la pièce à travailler (P), et
le système de communication comprend en outre :
une unité de commande (201) configurée pour actionner la partie mobile (50, 28) sur la base de données de résultat de traitement du traitement d'image réalisé par le dispositif de formation d'image (96, 98) ;
un premier moyen de communication (221, 222, 224, 225) configuré pour transmettre les données de résultat de traitement à l'unité de commande (201) depuis le dispositif de formation d'image (96, 98) ; et
un second moyen de communication (217, 237) différent du premier moyen de communication (221, 222, 224, 225),
**caractérisé en ce que**
l'unité de commande (201) est configurée pour transmettre les données d'image depuis le dispositif de formation d'image (96, 98), sur la base des données de résultat de traitement, via le second moyen de communication (217, 237), et
dans lequel le système de communication est configuré de façon que, lorsqu'il est déterminé que la pièce à travailler (P) n'est pas maintenue normalement par la partie mobile (50, 28) sur la base des données de résultat de traitement, l'unité de commande (201) permet au second moyen de communication (217, 237) de transmettre les données d'image.

2. Système de communication selon la revendication 1,
dans lequel le second moyen de communication (217, 237) est un dispositif de communication permettant de transmettre des données, en quantité supérieure à la quantité des données de résultat de traitement dont la transmission est permise par la configuration du premier moyen de communication (221, 222, 224, 225), par communication en champ proche.

3. Système de communication selon la revendication 1 ou 2,
dans lequel le second moyen de communication (217, 237) est un dispositif de communication qui est configuré pour réaliser une communication en champ proche bidirectionnelle, et
lors d'un changement de type de pièce à travailler (P) devant être maintenue par la partie mobile (50, 28), l'unité de commande (201) transmet au dispositif de formation d'image (96, 98), depuis l'unité de commande (201) via le second moyen de communication (217, 237), des données de réglage en lien avec le traitement d'image du dispositif de formation d'image (96, 98), qui correspondent à une pièce à travailler (P) changée.

4. Système de communication selon l'une quelconque des revendications 1 à 3,
dans lequel l'unité de commande (201) comprend une unité de stockage (122, 106) configurée pour mettre au rebut la pièce à travailler (P) lorsqu'il est déterminé que la pièce à travailler (P) n'est pas maintenue normalement par la partie mobile (50, 28),
le second moyen de communication (217, 237) comprend une unité réceptrice (217) qui est située dans l'unité de stockage (122, 106) et se trouve face au dispositif de formation d'image (96, 98) lorsque l'unité de commande déplace la partie mobile (50, 28) vers l'unité de stockage (122, 106) pour mettre au rebut la pièce à travailler (P).

5. Système de communication selon la revendication 4,
dans lequel l'unité de commande (201) est configurée pour réaliser un traitement destiné à la mise au rebut de la pièce à travailler (P) par la partie mobile (50, 28) parallèlement à un traitement destiné à la transmission des données d'image à l'unité réceptrice (217) depuis le dispositif de formation d'image (96, 98) via le second moyen de communication (217, 237).

6. Système de communication selon l'une quelconque des revendications 1 à 5,
dans lequel le premier moyen de communication (221, 222, 224, 225) est un dispositif de communication qui est configuré pour réaliser une communication sans fil optique en multiplexage bidirectionnel, et
l'unité de commande (201) est configurée pour transmettre des données de commande, qui actionnent la partie mobile (50, 28), via le premier moyen de communication (221, 222, 224, 225).

7. Dispositif de montage de composant électronique, comprenant le système de communication selon l'une quelconque des revendications 1 à 6,
le dispositif étant configuré pour transmettre des données relatives à un travail de montage d'un composant électronique, qui est maintenu en tant que pièce à travailler (P) par la partie mobile (50, 28), sur une carte de circuit via le système de communication.
